# NOUVEAU FASCICULE DE BREVET EUROPEEN

(11) **EP 0 533 555 B2**
(45) Date de publication et mention de la décision concernant l'opposition: **22.08.2001**
(45) Mention de la délivrance du brevet: 13.03.1996
(21) Numéro de dépôt: 92402527.3
(22) Date de dépôt: 16.09.1992
(51) Int. Cl.: H02B 1/30, A47B 57/44

(54) **Profilé d'ossature avec un accessoire d'équipement**
Skelettprofil mit einer Zubehöranordnung
Frame structure with an accessory equipment

(30) Priorité: 18.09.1991 FR 9111483
(43) Date de publication de la demande: 24.03.1993
(73) Titulaire: LEGRAND, F-87045 Limoges Cédex (FR)
(72) Inventeur: Baudouin, Pascal, F-76380 Canteleu (FR); Bouteiller, Pascal, F-76160 Darnetal (FR); Desforges, Rémi, F-76850 Bosc le Hard (FR)
(74) Mandataire: CABINET BONNET-THIRION

(56) Documents cités:
- EP-A- 0 402 276
- EP-B- 0 157 344
- WO-A-91/018436
- DE-A- 1 910 658
- DE-A- 4 013 381
- DE-U- 8 910 312

## Description

La présente invention concerne d'une manière générale les profilés mis en oeuvre pour la constitution d'une ossature, notamment lorsqu'une telle ossature est destinée à la réalisation d'une armoire pour appareillages électriques.

Elle vise plus particulièrement, mais non nécessairement exclusivement, le cas où cette armoire est une armoire dite assemblable, c'est-à-dire une armoire dont le montage final peut si désiré être effectué in situ.

Dans tous les cas, l'ossature sur la base de laquelle est constituée l'armoire a une double fonction.

D'une part, elle doit porter, intérieurement, les éléments de structure propres au support des appareillages électriques concernés, et, d'autre part, elle doit porter, extérieurement, l'habillage propre à en confiner le volume.

Indépendamment d'un socle sur lequel repose l'ensemble, cet habillage est usuellement formé d'une porte, d'une paroi de fond, de deux parois latérales, et d'un toit.

Il est donc nécessaire de rapporter sur les profilés constituant l'ossature des accessoires d'équipement propres à la mise en oeuvre de certains au moins de ces éléments.

Il s'agit par exemple de charnons pour l'articulation de la porte.

A ce jour, les divers accessoires d'équipement nécessaires sont directement rapportés sur les profilés d'ossature, et, plus précisément, sur une paroi de ceux-ci dite ci-après, par simple commodité, paroi de fermeture.

C'est le cas tant dans le brevet européen qui, déposé le 3 Décembre 1984, sous le No 84114687.1, a été publié sous le No 0144955 que dans la demande de brevet européen qui, déposée le 18 Mai 1990, sous le No 90420242.1, a été publiée sous le No 0402276.

Dans l'un et l'autre cas, il résulte de cette fixation directe des accessoires d'équipement sur la paroi de fermeture des profilés d'ossature une certaine complexité de mise en place lors du montage final de l'armoire, ce qui peut constituer un réel inconvénient lorsque ce montage final a lieu in situ.

Il en est d'autant plus ainsi que cette fixation se fait en pratique à l'aide de vis, à raison de surcroît de plusieurs vis pour un même accessoire d'équipement, et que, sur le site concerné, la manipulation de telles vis peut s'avérer malaisée.

La présente invention a d'une manière générale pour objet une disposition permettant au contraire de faciliter le montage final de l'armoire concernée, notamment lorsque ce montage se fait in situ, et conduisant en outre à d'autres avantages.

De manière plus précise, elle a tout d'abord pour objet un profilé d'ossature selon la revendication 1 ; elle a encore pour objets divers accessoires d'équipement ainsi susceptibles d'être associés à un tel profilé d'ossature.

En pratique, le profilé d'ossature suivant l'invention est systématiquement équipé, par avance, en atelier, de plusieurs noix, qui, toutes identiques, sont dûment échelonnées, à des endroits choisis, sur sa hauteur.

Toutes ces noix sont aptes à recevoir, de manière indifférenciée, un quelconque accessoire d'équipement.

Il en résulte, avec une grande souplesse d'emploi, une mise en place aisée des divers accessoires d'équipement nécessaires.

En pratique, cette mise en place est d'autant plus facile qu'elle se fait avec un simple axe à tête épaulée, sans qu'il soit nécessaire de faire appel à un quelconque outil.

Il résulte, également, de la présence systématique de noix sur la paroi de fermeture du profilé d'ossature suivant l'invention que les montants d'une ossature réalisés avec de tels profilés d'ossature sont avantageusement identiques entre eux, en admettant tous un plan longitudinal de symétrie et un plan transversal de symétrie, ce qui permet de les substituer de manière indifférenciée les uns aux autres, et ce qui permet donc de simplifier avantageusement la réalisation de l'ensemble.

Il en résulte, de plus, que tout changement de main pour la porte concernée se trouve lui-même simplifié, ce changement de main n'imposant pas d'avoir à intervenir sur les montants latéraux de l'ossature correspondante autrement que pour y mettre les accessoires d'équipement nécessaires.

Il en résulte, enfin, que, la noix suivant l'invention étant rapportée en atelier sur la paroi de fermeture à équiper, l'étanchéité de celle-ci se trouve rétablie dans des conditions avantageusement plus sûres que celles susceptibles de présider à une fixation directe des accessoirs d'équipement correspondants sur cette paroi de fermeture lorsque cette fixation est effectuée in situ.

Les objets de l'invention, leurs caractéristiques et leurs avantages, ressortiront d'ailleurs de la description qui va suivre, à titre d'exemple, en référence aux dessins schématiques annexés sur lesquels :
la figure 1 est une vue partielle en perspective d'un profilé d'ossature suivant l'invention, vu de l'avant ;
la figure 2 en est une vue partielle en perspective, vu de l'arrière, avant qu'il lui soit rapporté une noix ;
la figure 3 en est une vue en coupe transversale, suivant la ligne III-III de la figure 2;
la figure 4 en est, à échelle inférieure, une vue partielle en élévation, suivant la flèche IV de la figure 3 ;
la figure 5 est une vue partielle en perspective analogue à celle de la figure 2, après qu'une noix ait été rapportée sur le profilé d'ossature suivant l'invention ;
la figure 6 est, à la manière de la figure 3, une vue en coupe transversale passant par cette noix, suivant la ligne VI-VI de la figure 5 ;
la figure 7 est une vue en perspective de cette seule noix, représentée isolément, vue de l'avant ;
la figure 8 en est une vue en perspective, vue de l'arrière, suivant la flèche VIII de la figure 7 ;
les figures 9, 10 et 11 en sont des vues en coupe longitudinale, suivant, chacune respectivement, les lignes IX-IX, X-X et XI-XI de la figure 7 ;
la figure 12 en est une vue en coupe transversale, suivant la ligne XII-XII de la figure 7 ;
la figure 13 est une vue en perspective d'un premier accessoire d'équipement susceptible d'être rapporté sur le profilé d'ossature suivant l'invention ;
les figures 14A, 14B sont des vues en perspective illustrant la mise en oeuvre de cet accessoire d'équipement ;
les figures 15, 16A et 16B sont des vues en perspective qui, analogues chacune respectivement aux figures 13, 14A et 14B, se rapportent à un deuxième accessoire d'équipement ;
la figure 17 est une vue en perspective illustrant la mise en oeuvre conjointe des deux accessoires d'équipement précédents ;
la figure 18 est une vue en coupe transversale, qui, analogue à celles des figures 3 et 6, illustre elle aussi la mise en oeuvre conjointe de ces deux accessoires d'équipement ;
la figure 19 est une vue en perspective d'un troisième accessoire d'équipement susceptible d'être associé au profilé d'ossature suivant l'invention ;
la figure 20 est une vue en coupe transversale, qui, du même type que celles des figures 3, 6 et 18, illustre la mise en oeuvre de ce troisième accessoire d'équipement ;
la figure 21 est une vue en perspective d'un quatrième accessoire d'équipement susceptible d'être associé au profilé d'ossature suivant l'invention ;
la figure 22 est une vue en perspective d'un cinquième accessoire d'équipement susceptible d'être associé au profilé d'ossature suivant l'invention ;
la figure 23 est une vue en coupe transversale qui, du même type que celles des figures 3, 6, 18 et 20, illustre la mise en oeuvre de ce cinquième accessoire d'équipement ;
la figure 24 est une vue en perspective qui, analogue à celle de la figure 7, mais à une échelle supérieure, se rapporte à une variante de réalisation de la noix susceptible d'être rapportée par avance sur le profilé suivant l'invention ;
la figure 25 est une autre vue en perspective, vue de l'arrière, de cette noix ;
la figure 26 est une vue en perspective illustrant une autre fonction d'une des noix rapportées par avance sur le profilé d'ossature suivant l'invention ;
la figure 27 est, à échelle supérieure, une vue en coupe transversale du profilé d'ossature ainsi équipé de cette noix, suivant la ligne XXVII-XXVII de la figure 26 ;
la figure 28 en est une vue en coupe longitudinale, suivant la ligne XXVIII-XXVIII de la figure 26.

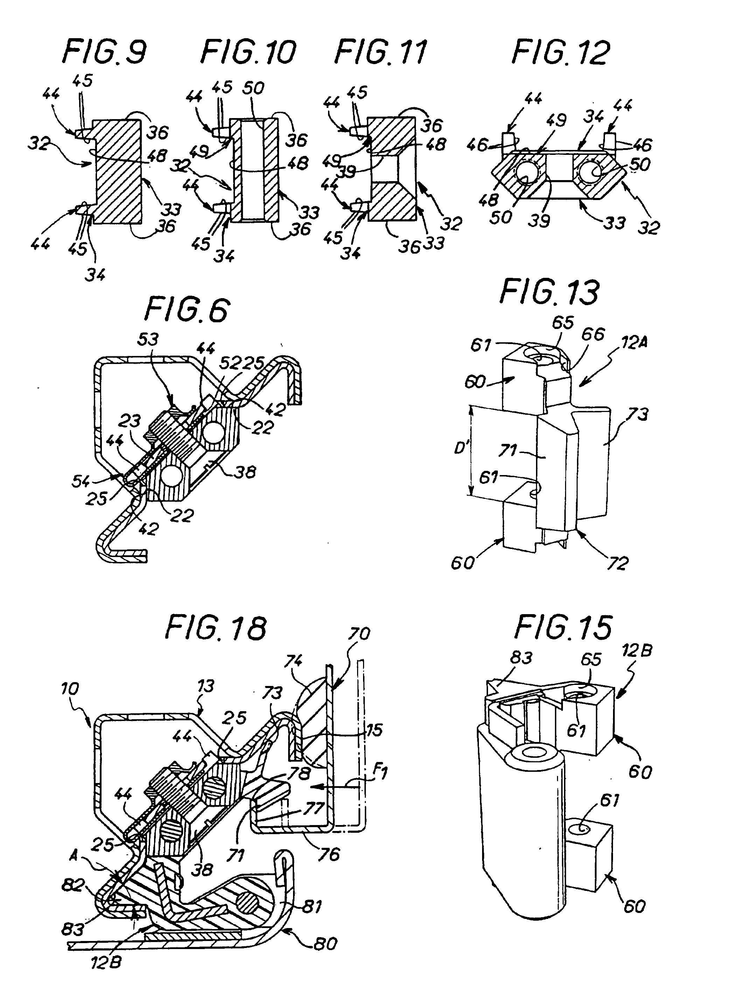

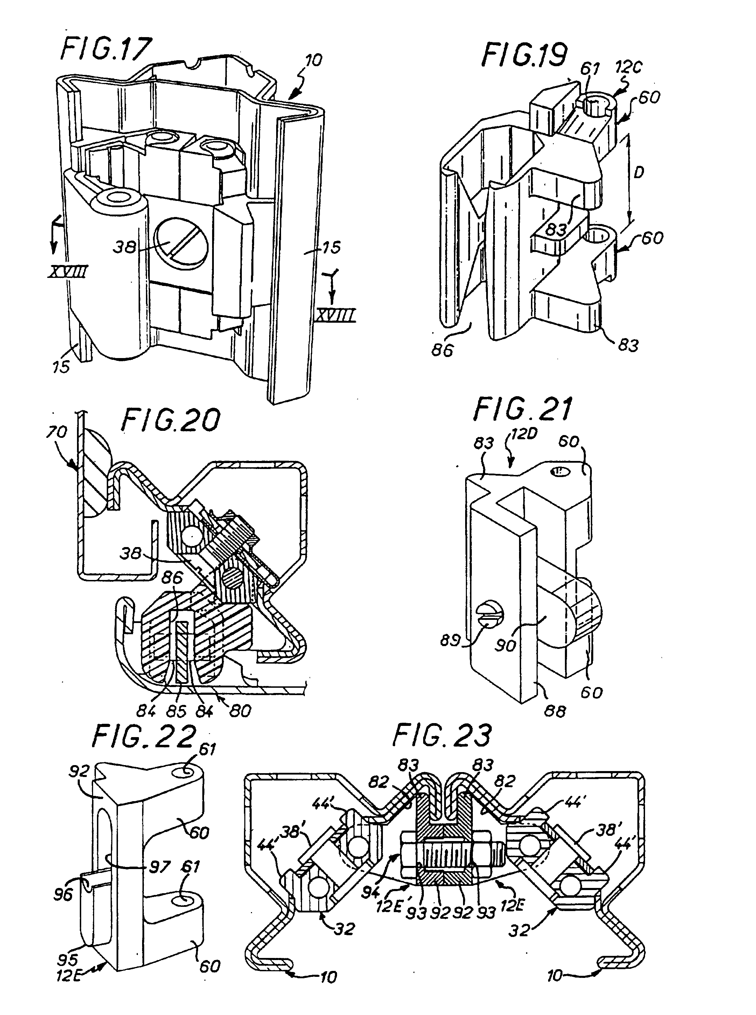

Tel qu'illustré sur ces figures, il s'agit, globalement, d'un quelconque profilé d'ossature 10, qui, suivant des modalités qui, ne relevant pas de la présente invention, ne seront pas décrites ici, est destiné à constituer, avec d'autres, une ossature, en particulier celle d'une armoire pour appareillages électriques, et sur une paroi 11 duquel, dite ici par simple commodité paroi de fermeture, doit être rapporté au moins un accessoire d'équipement désigné ci-après par la référence générale 12, à savoir, par exemple, en vue de fonctions explicitées ultérieurement, un embout 12A, figure 13, un charnon 12B, figure 15, une gâche 12C, figure 19, un verrou 12D, figure 21, ou un étrier d'assemblage 12E, figure 22.

Le profilé d'ossature 10 ne relevant pas par lui-même de la présente invention, et pouvant de surcroît relever de réalisations différentes, il ne sera pas décrit dans tous ses détails ici.

Seuls en seront plus précisément mentionnés les éléments nécessaires à la compréhension de l'invention.

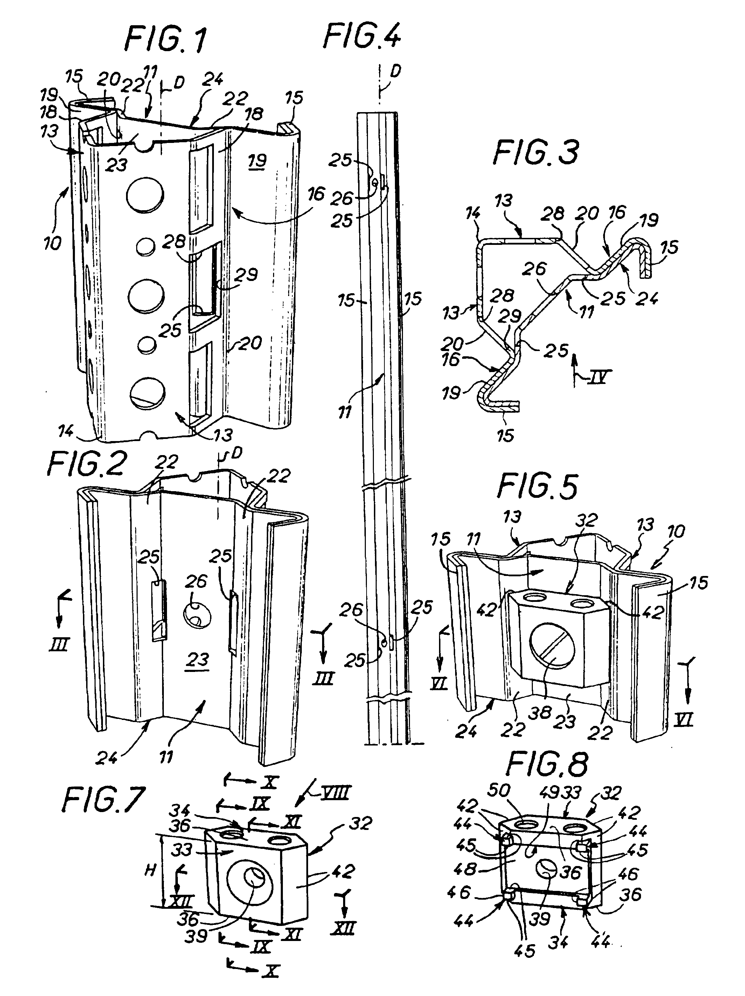

Soit D, tel que schématisé en traits interrompus sur les figures 1, 2 et 4, sa direction d'allongement.

Dans la forme de réalisation représentée, ce profilé d'ossature 10 comporte, globalement, deux ailes 13, qui s'étendent globalement à l'équerre l'une par rapport à l'autre, en formant conjointement une arête 14 en avant de la paroi de fermeture 11, et qui présentent chacune un retour 15 parallèle à l'autre le long de leur bord.

Les ailes 13 présentent, en outre, chacune, en creux, entre leur arête 14 et leur retour 15, un décrochement 16, formé, en angle rentrant, de deux pans 18, 19, et la paroi de fermeture 11 les relie globalement l'une à l'autre au droit de ce décrochement 16, et, plus précisément, au droit de l'arête 20 commune aux deux pans 18, 19 de celui-ci.

Les pans 19 des décrochements 16 les plus éloignés de l'arête 14 sont coplanaires.

Dans la forme de réalisation représentée, la paroi de fermeture 11 présente latéralement des parties de raccordement 22, qui, encadrant sa partie médiane 23, sont obliques par rapport à celle-ci, cette partie médiane 23 étant décalée transversalement en direction de l'arête 14, et, en pratique, elle appartient à un flasque 24, qui se prolonge latéralement tant le long du pan 19 du décrochement 16 des ailes 13 le plus éloigné de l'arête 14 que le long de leur retour 15.

De place en place sur sa hauteur, la paroi de fermeture 11 comporte un jeu de deux évidements 25, de contour quadrangulaire, qui, allongés en boutonnière parallèlement à la direction d'allongement D, affectent chacun respectivement ses parties de raccordement 22, figure 2, en mordant légèrement sur sa partie médiane 23, avec, entre eux, un perçage 26, de contour circulaire.

L'une au moins des ailes 13, et en pratique chacune de celles-ci, présente au droit des évidements 25 de la paroi de fermeture 11, entre celle-ci et l'arête 14, un évidement 28, de contour quadrangulaire, qui, allongé en boutonnière parallèlement à la direction d'allongement D, est propre, ainsi qu'il sera explicité ultérieurement, au passage d'un écrou.

En pratique, la tranche 29 de cet évidement 28 la plus éloignée de l'arête 14 s'étend au-delà de la partie médiane 23 de la paroi de fermeture 11 par rapport à cette arête 14, en sorte que, à la faveur des évidements 25 des parties de raccordement 22 de la paroi de fermeture 11, elle donne accès à cette partie médiane 23.

Suivant l'invention, la paroi de fermeture 11 du profilé d'ossature 10 ainsi constitué est équipée par avance d'au moins une noix 32, qui, en saillie sur la surface externe de cette paroi de fermeture 11, figure 5, est apte à recevoir un quelconque au moins des accessoires d'équipement 12.

En pratique, la paroi de fermeture 11 porte, par avance, à distance les unes des autres, plusieurs noix 32, à raison d'une par jeu d'évidements 25.

Toutes ces noix 32 sont identiques entre elles.

Dans la forme de réalisation représentée, et ainsi qu'il est plus particulièrement visible sur les figures 7 à 12, une noix 32 se présente sous la forme générale d'une plaquette relativement massive, dont les faces principales avant 33 et arrière 34 sont parallèles à la paroi de fermeture 11, et plus précisément à la partie médiane 23 de celle-ci, et dont les tranches supérieure et inférieure 36, non différenciées, s'étendent parallèlement l'une à l'autre, perpendiculairement à la direction d'allongement D.

Soit H la hauteur de la noix 32 mesurée d'une de ses tranches supérieure et inférieure 36 à l'autre, parallèlement à la direction d'allongement D.

La face principale arrière 34 forme la face d'appui par laquelle une telle noix 32 est apte à être adossée à la paroi de fermeture 11.

Pour le passage d'un quelconque organe de fixation, par exemple une vis 38, propre à sa fixation à cette paroi de fermeture 11 suivant des modalités qui seront décrites plus en détail ultérieurement, la noix 32 comporte, sur toute son épaisseur, c'est-à-dire perpendiculairement à la face principale arrière 34 formant sa face d'appui, au moins un perçage 39, dit ci-après par simple commodité perçage transversal, en correspondance avec le perçage 26 concerné de la paroi de fermeture 11.

A son débouché sur la face principale avant 33, ce perçage transversal 39 va en s'évasant.

Dans la forme de réalisation représentée, la noix 32 ne comporte qu'un perçage transversal 39, et il lui est associé des moyens de blocage en rotation propres à en assurer le maintien autour de son axe.

En pratique, la noix 32 s'étend latéralement jusqu'aux parties de raccordement 22 de la paroi de fermeture 11, figures 5 et 6, et les moyens de blocage en rotation qui lui sont associés résultent, notamment, de ce que, pour contact avec ces parties de raccordement 22, elle présente, latéralement, de manière complémentaire, sur la face principale arrière 34 formant sa face d'appui, des facettes obliques 42.

Dans la forme de réalisation représentée, la face principale avant 33 forme elle aussi latéralement, de manière symétrique avec les précédentes, des facettes obliques 42.

Ainsi, dans cette forme de réalisation, les tranches latérales de la noix 32 sont chacune biseautées en coin par deux facettes obliques 42 qui s'étendent globalement parallèlement à la direction d'allongement D.

En section transversale, la noix 32 a donc un profil en navette.

Sur sa face principale arrière 34 formant sa face d'appui, la noix 32 présente, en outre, en saillie, au moins un ergot 44, 44' en correspondance avec un évidement 25 de la paroi de fermeture 11.

En pratique, dans la forme de réalisation plus particulièrement représentée sur les figures 1 à 20, elle présente ainsi en saillie, sur sa face principale arrière 34 formant sa face d'appui, quatre ergots 44, disposés chacun respectivement aux sommets d'un quadrilatère rectangle dont deux des côtés sont parallèles à la direction d'allongement D et les deux autres perpendiculaires à celle-ci, à raison de deux pour chacun des deux évidements 25 concernés de la paroi de fermeture 11.

Ces ergots 44, dont la racine s'étend pour partie sur la partie médiane courante de la face principale arrière 34 formant la face d'appui de la noix 32 et pour partie sur les facettes obliques 42 de celle-ci, ont, en section transversale, dans la forme de réalisation représentée, un contour globalement quadrangulaire, et en pratique carré, et leur extrémité est plane.

Celles, 45, des faces latérales de ces ergots 44 qui s'étendent globalement transversalement par rapport à la direction d'allongement D sont en biais, en convergeant l'une vers l'autre, pour un même ergot 44, de la racine de cet ergot 44 à son extrémité.

Pour un même ergot 44, l'une au moins des faces latérales 46 qui s'étendent globalement parallèlement à la direction d'allongement D est également en biais, en convergeant vers l'autre de la racine de cet ergot 44 à son extrémité.

Dans la forme de réalisation représentée, seule la face latérale 46 interne des ergots 44 est ainsi en biais.

Entre les ergots 44, la face principale arrière 34 de la noix 32 formant la face d'appui de celle-ci est affectée, transversalement, sur toute sa largeur, d'un lamage 48.

Autrement dit, elle présente, en creux sur sa partie courante, une rainure 49, qui court sur toute sa largeur, et dont le fond forme le lamage 48.

Enfin, pour un assujettissement à elle d'un quelconque accessoire d'équipement 12, suivant des modalités décrites plus en détail ultérieurement, la noix 32 comporte, sur toute sa hauteur, parallèlement à la face principale arrière 34 formant sa face d'appui, et parallèlement à la direction d'allongement D, au moins un perçage 50, dit ci-après par simple commodité perçage longitudinal, apte à la mise en place d'un organe de retenue.

Dans la forme de réalisation représentée, la noix 32 comporte ainsi parallèlement l'un à l'autre deux perçages longitudinaux 50, qui, disposés chacun respectivement de part et d'autre de son perçage transversal 39, sont l'un et l'autre à distance de celui-ci.

Pour sa mise en place, la noix 32 est engagée par ses ergots 44 dans les évidements 25 concernés de la paroi de fermeture 11 du profilé d'ossature 10.

Cet engagement se trouve facilité par l'obliquité de la face latérale 46 interne de ces ergots 44 aussi bien que par celle de leur face latérale 45 externe, ces diverses faces étant susceptibles de venir porter sur les tranches correspondantes des évidements 25.

Les ergots 44 de la noix 32 assurent ainsi un positionnement et un centrage précis de celle-ci par rapport au profilé d'ossature 10.

Ils sont également susceptibles d'en assurer un blocage en rotation sur ce profilé d'ossature 10.

Mais, pour l'essentiel, et comme indiqué précédemment, ce blocage en rotation résulte de ce que, au terme de sa mise en place, la noix 32 porte par les facettes obliques 42 de sa face principale arrière 34 formant sa face d'appui contre les parties de raccordement 22 de la paroi de fermeture 11 du profilé d'ossature 10, figure 6.

Quoi qu'il en soit, au terme de cette mise en place, le perçage transversal 39 de la noix 32 se trouve au droit du perçage 26 correspondant de la paroi de fermeture 11, et, du fait de son lamage 48, il subsiste, entre elle et la partie médiane 23 de cette paroi de fermeture 11, un espace libre 52, figure 6.

Si désiré, et comme représenté, cet espace libre 52 est mis à profit pour la mise en place, sur la partie médiane 23 de la paroi de fermeture 11, à la faveur, d'une part, de l'évidement 25 d'une des parties de raccordement 22 de celle-ci, et, d'autre part, de l'évidement 28 de l'aile 13 à laquelle cette partie de raccordement 22 est adjacente, d'un écrou 53 du type de ceux commercialisés sous la dénomination "RAPID".

Il s'agit d'un écrou dûment solidaire d'une des ailes d'une agrafe en U 54 dont l'autre aile est glissée dans l'espace libre 52, entre la partie médiane 23 de la paroi de fermeture 11 et la noix 32.

Mais, en variante, et suivant des dispositions qui, ne relevant pas de la présente invention, ne seront pas décrites ici, il peut être substitué, à un tel écrou "RAPID" 53, un quelconque écrou massif.

Quoi qu'il en soit, il suffit, ensuite, de mettre en oeuvre la vis 38, pour que la noix 32 soit dûment assujettie au profilé d'ossature 10.

Il peut être procédé ainsi pour chacun des jeux d'évidements 25 que comporte la paroi de fermeture 11 de ce profilé d'ossature 10.

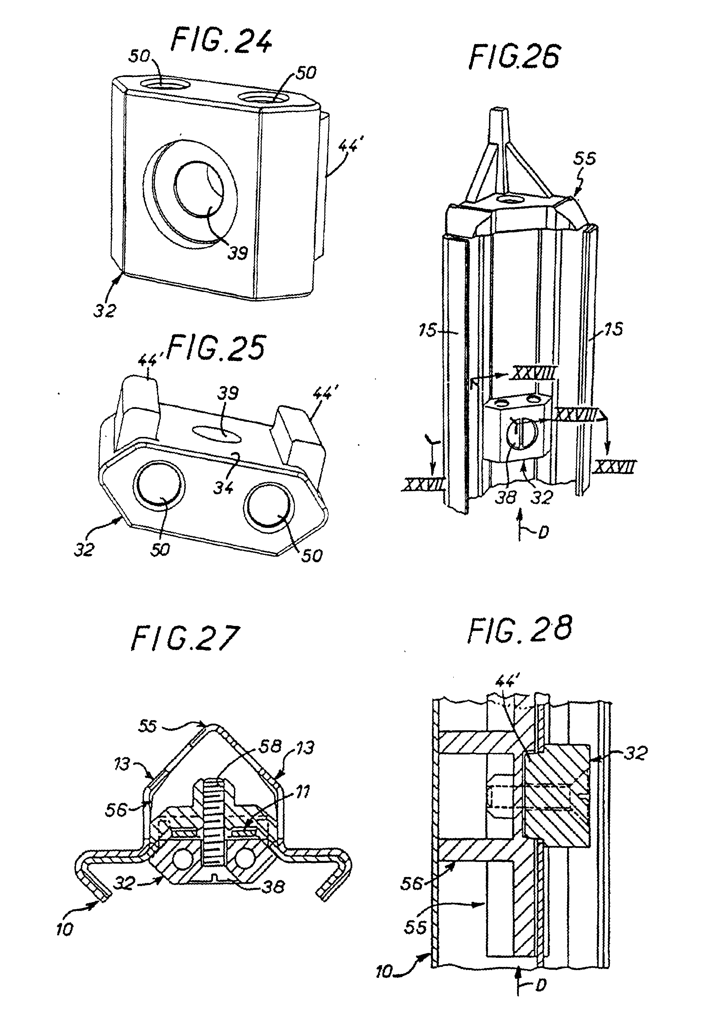

Cependant, et tel qu'illustré par les figures 26 à 28, les noix 32 les plus proches des extrémités de ce profilé d'ossature 10 sont mises à profit pour participer à la fixation à celui-ci de jambages 55 propres à permettre de le relier en trièdre à deux autres profilés d'ossature 10 déjà reliés en équerre par une quelconque pièce d'assemblage appropriée.

Les dispositions correspondantes ne relevant pas de la présente invention, elles ne seront pas décrites ici.

Il suffira d'indiquer que le jambage 55 comporte un pied-droit 56, qui est engagé dans le canal tubulaire que définissent avec la paroi de fermeture 11 les ailes 13 du profilé d'ossature 10, et que, pour coopération avec la vis 38, ce pied-droit 56 présente transversalement un perçage taraudé 58.

Les noix 32 correspondantes sont donc rapportées sur la paroi de fermeture 11 du profilé 10 par l'intermédiaire des jambages 55 engagés dans celui-ci.

Conjointement, chacune des noix 32 intermédiaires entre les extrémités du profilé d'ossature 10 sont chacune individuellement directement rapportées sur sa paroi de fermeture 11.

Chacune des noix 32 dont est ainsi équipé de place en place le profilé d'ossature 10 sur sa paroi de fermeture 11 peut elle-même être mise à profit pour la fixation à celui-ci d'un quelconque accessoire d'équipement 12.

Pour ce faire, cet accessoire d'équipement 12, qu'il s'agisse de l'embout 12A, du charnon 12B, de la gâche 12C, du verrou 12D ou de l'étrier d'assemblage 12E, présente deux bras 60 par lesquels il est apte à être engagé, à la manière d'une chape, sur une telle noix 32.

Autrement dit, ces bras 60, qui s'étendent parallèlement l'un à l'autre, sont établis à une distance D' l'un de l'autre sensiblement égale à la hauteur H de la noix 32, tout en étant légèrement supérieure à celle-ci.

En pratique, ces bras 60 forment des oreilles.

Autrement dit, ils présentent chacun un perçage 61 pour le passage d'un organe de retenue 62.

Suivant l'invention, cet organe de retenue 62 est un simple axe à tête épaulée 64.

Ainsi, le montage final de l'armoire concernée ne nécessite aucun outil particulier pour la mise en place des accessoires d'équipement 12 à mettre en oeuvre.

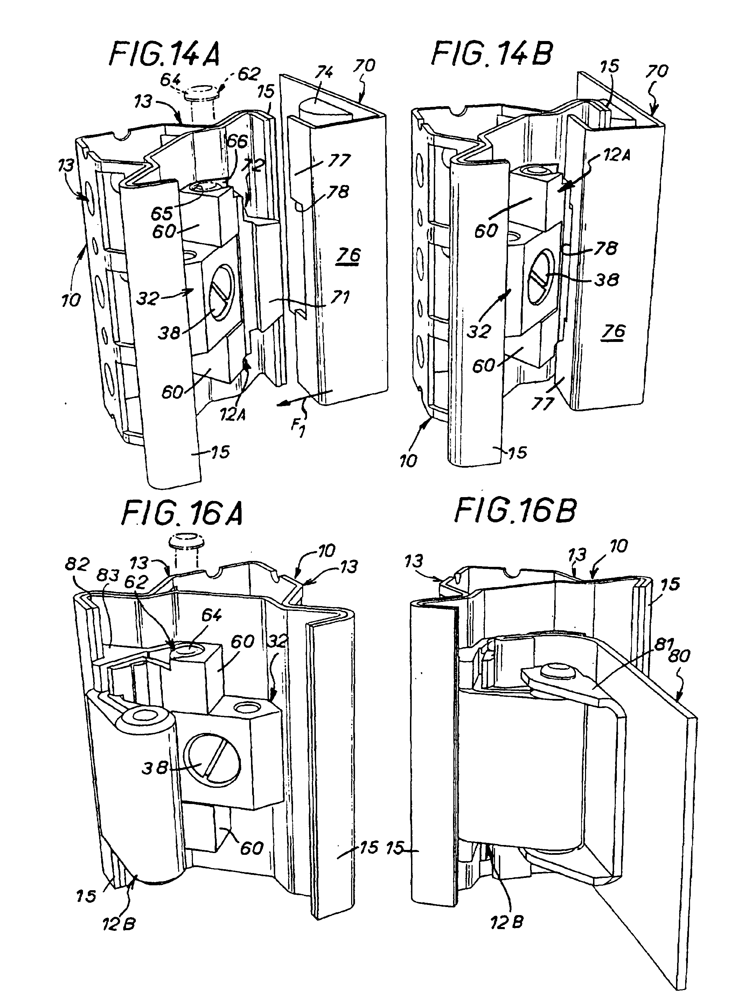

Il suffit, en effet, après avoir procédé à un alignement des perçages 61 des bras 60 de cet accessoire d'équipement 12 avec le perçage longitudinal 50 correspondant de la noix 32 choisie, de procéder à un engagement par le haut de l'organe de retenue 62 dans les perçages 50 et 61 ainsi alignés, tel que schématisé en traits interrompus sur la figure 14A pour l'embout 12A, et sur la figure 16A pour le charnon 12B, puis de laisser aller par simple gravité cet organe de retenue 62.

Préférentiellement, et tel que représenté, le perçage 61 du bras 60 supérieur des accessoires d'équipement 12 forme à son débouché supérieur un dégagement 65, dans lequel peut s'encastrer la tête épaulée 64 de l'axe formant l'organe de retenue 62, en s'escamotant ainsi dans l'épaisseur même de ce bras 60, et qui débouche latéralement par une encoche 66 donnant accès à cette tête épaulée 64 lorsqu'une dépose s'avère nécessaire.

L'embout 12A représenté à la figure 13 constitue un accessoire d'équipement, qui, susceptible d'être associé, suivant les dispositions précédemment décrites, à un profilé d'ossature 10, est apte à l'encliquetage sur celui-ci d'une paroi latérale 70 de l'armoire concernée.

Pour ce faire, cet embout 12A est doté d'un crochet 71.

En pratique, ce crochet 71 s'étend sur toute la hauteur de la partie médiane 72 reliant l'un à l'autre les bras 60 correspondants.

Dans la forme de réalisation représentée, l'embout 12A présente, en outre, pour appui sur le profilé d'ossature 10, une languette élastiquement déformable 73.

Par exemple, et tel que représenté, cette languette élastiquement déformable 73 est d'un seul tenant avec l'embout 12A, en venant de moulage avec lui.

En variante, il s'agit d'un insert (non représenté).

En pratique, cette languette élastiquement déformable 73 s'étend elle aussi sur toute la hauteur de la partie médiane 72 de l'embout 12A, en formant un dièdre avec son crochet 71.

Conjointement, la paroi latérale 70, qui est équipée d'un joint d'étanchéité 74 pour son contact avec le retour 15 de l'aile 13 correspondante du profilé d'ossature 10, présente, au-delà de ce joint d'étanchéité 74, un rebord 76 muni d'un retour 77, et celui-ci est affecté d'une encoche 78 par laquelle il est apte à s'engager sur le crochet 71.

Dès lors, le profilé d'ossature 10 étant équipé d'au moins un tel embout 12A, il suffit, la paroi latérale 70 étant suspendue à la partie haute de l'ossature correspondante, suivant des dispositions ne relevant pas de la présente invention, en étant initialement écartée du profilé d'ossature 10, tel que représenté en trait continu sur la figure 14A et tel que schématisé en traits interrompus sur la figure 18, de rapprocher cette paroi latérale 70 de ce profilé d'ossature 10, suivant la flèche F1 des figures 14A et 18, avec compression concomitante de son joint d'étanchéité 74, jusqu'à ce que, tel que représenté en trait continu sur la figure 14B et sur la figure 18, elle vienne s'encliqueter, par l'encoche 78 du retour 77 de son rebord 76, sur le crochet 71 de l'embout 12A, avec une déformation élastique concomitante de la languette élastiquement déformable 73 de celui-ci.

Le charnon 12B représenté sur la figure 15 constitue un accessoire d'équipement qui, associé au profilé d'ossature 10, est apte à l'articulation d'une porte 80 à celui-ci, cette porte 80 étant à cet effet équipée d'un charnon 81 complémentaire.

Il suffit, tout d'abord, de mettre en place, sur la noix 32 concernée, le charnon 12B, figure 16A, suivant les dispositions décrites précédemment.

Il suffit, ensuite, d'amener en prise avec ce charnon 12B le charnon 81 qui lui est associé.

Du fait que, comme indiqué précédemment, la tête épaulée 64 de l'axe formant l'organe de retenue 62 correspondant vient s'escamoter dans le dégagement 65 du bras 60 supérieur du charnon 12B, il n'est pas possible de retirer cet organe de retenue 62 lorsque la porte 80 est fermée.

Il faut au contraire, au bénéfice de la sécurité, ouvrir au préalable la porte 80.

Préférentiellement, et tel que représenté, lorsque, comme en l'espèce, les ailes 13 du profilé d'ossature 10 présentent chacune un retour 15 faisant avec leur partie immédiatement adjacente, en pratique le pan 19 de leur décrochement 16, un dièdre 82 d'angle aigu A, figure 18, l'accessoire d'équipement que constitue le charnon 12B présente un bossage 83, en forme de coin, qui, de section transversale au moins en partie complémentaire de celle de ce dièdre 82, est apte à s'encastrer dans celui-ci.

Il est ainsi avantageusement assuré une reprise locale d'effort entre le charnon 12B et le profilé d'ossature 10.

Dans la forme de réalisation représentée, ce bossage 83 s'étend sur toute la hauteur du charnon 128, de l'un à l'autre des bras 60 de celui-ci.

Sur l'accessoire d'équipement que constitue la gâche 12C représentée à la figure 19, il n'est prévu un tel bossage 83 qu'au droit de chacun des bras 60.

Pour le reste, cette gâche 12C ne relève pas de la présente invention, et elle ne sera donc pas décrite ici.

Il suffira d'indiquer qu'elle est destinée à coopérer en verrouillage avec des pênes 84 portés par une tringle de fermeture 85 qui, montée coulissante sur la porte 80, la traverse de part en part à la faveur d'une fente 86 qu'elle présente à cet effet.

Le verrou 12D représenté sur la figure 20 constitue un accessoire d'équipement qui, associé au profilé d'ossature 10, permet, si désiré, d'ouvrir à la manière d'une porte la paroi de fond, non représentée, de l'armoire concernée.

Comme précédemment, il comporte, pour sa mise en place sur un profilé d'ossature 10 équipé d'une noix 32, deux bras 60, et de l'un à l'autre de ceux-ci, un bossage 83 en forme de coin.

Il comporte en outre, articulé entre les flancs d'une chape 88 sous le contrôle d'une vis 89 accessible de l'extérieur à la faveur d'un trou prévu à cet effet dans la paroi de fond, un loquet 90 propre à venir se prendre derrière le retour du rebord que comporte cette paroi de fond à la manière de la paroi latérale 70 représentée sur la figure 18.

En pratique, deux verrous 12D sont ainsi prévus sur la hauteur de la paroi de fond, le long d'un des bords verticaux de celle-ci, et, le long de l'autre de ces bords verticaux, cette paroi de fond est articulée par des charnons, suivant les dispositions déjà décrites pour la porte 80.

Des dispositions du même type peuvent être reprises pour l'une quelconque des parois latérales 70.

Quoi qu'il en soit, il est ainsi avantageusement donné un accès supplémentaire au volume interne de l'armoire concernée, par exemple pour le câblage des appareillages électriques qu'elle contient.

Bien entendu, et tel que représenté sur les figures 17 et 18, où il s'agit, d'une part, d'un embout 12A, et, d'autre part, d'un charnon 12B, une même noix 32 peut porter deux accessoires d'équipement 12.

L'étrier d'assemblage 12E représenté sur la figure 22 est propre à participer, avec un autre étrier d'assemblage 12E' de même type, à l'assujettissement l'un à l'autre de deux profilés d'ossature 10 adjacents, tel que représenté sur la figure 23, notamment pour l'assemblage côte à côte de deux armoires.

Comme précédemment, il comporte, reliés l'un à l'autre en forme de chape par une partie médiane 92, deux bras 60 à perçage 61, et, de l'un à l'autre de ces bras 60, le long de la partie médiane 92, un bossage 83 en forme de coin.

La partie médiane 92 présente transversalement un perçage 93 pour le passage d'une vis 94.

D'un côté de ce perçage 93, la partie médiane 92 présente en saillie à son dos un tenon 95, qui, dans l'alignement du perçage 93, forme un berceau 96.

De l'autre côté du perçage 93, la partie médiane 92 présente en creux un évidement 97 complémentaire du tenon 95.

Pour l'étrier d'assemblage 12E, le bossage 83 en forme de coin s'étend d'un premier côté de la partie médiane 92 ; pour l'étrier d'assemblage 12E', il s'étend du côté opposé.

Ainsi, pour l'assujettissement l'un à l'autre de deux profilés d'ossature 10 adjacents, figure 23, ces étriers d'assemblage 12E, 12E' sont associés dos à dos, par leur partie médiane 92, avec leurs bossages 83 en forme de coin respectifs en prise avec les dièdres 82 correspondants de ces profilés d'ossature 10, et leurs bras 60 engagés sur les noix 32 de même niveau de ceux-ci.

Conjointement, le tenon 95 de chacun de ces étriers d'assemblage 12E, 12E' est en prise avec l'évidement 97 de l'autre.

De l'un à l'autre des étriers d'assemblage 12E, 12E', les tenons 95 forment par leur berceau 96 un conduit, qui, dans l'axe de leur perçage 93, est propre au passage de lavis 94.

Au cours du vissage de cette dernière, les tenons 95 assurent un guidage l'un par rapport à l'autre de ces deux étriers d'assemblage 12E, 12E'.

L'assujettissement l'un à l'autre des deux profilés d'ossature 10 peut donc avantageusement se faire en deux temps, avec, dans un premier temps, un rapprochement approximatif facilitant la mise en place des divers étriers d'assemblage 12E, 12E', et, dans un deuxième temps, un rapprochement définitif par serrage de la vis 94.

Au terme de ce serrage, les tenons 95 des étriers d'assemblage 12E, 12E' contrebutent avantageusement la vis 94, et ils lui évitent ainsi de travailler au cisaillement.

Dans ce qui précède, l'assujettissement l'un à l'autre de deux profilés d'ossature 10 se fait par l'extérieur de ceux-ci.

En variante, suivant des dispositions ne relevant pas de la présente invention parce qu'elles ne font pas appel aux noix 32, il peut également se faire par l'intérieur de ces profilés d'ossature 10.

Dans la forme de mise en oeuvre représentée sur la figure 23, et ainsi qu'il est mieux visible, isolément, sur les figures 24 et 25, chacune des noix 32 ne présente en saillie sur sa face d'appui 34 que deux ergots 44', qui, parallèles l'un à l'autre, et parallèles à la direction d'allongement D des profilés d'ossature 10 concernés, sont allongés suivant cette direction d'allongement D.

Ces ergots 44' étant ainsi plus massifs, la noix 32 s'en trouve renforcée.

Tel que représenté sur les figures 26 à 28, cette forme de réalisation à deux ergots 44' est donc préférée pour les jambages 55, pour lesquels la noix 32 fait clavette parallèlement à la direction d'allongement D, comme cela est notamment le cas lors d'un levage de l'armoire concernée.

Par ailleurs, dans cette forme de réalisation, la face d'appui 34 d'une noix 32 est plate, la fixation se faisant non plus à l'aide d'une vis 38 destinée à coopérer avec un écrou "RAPID", mais plus directement par un rivet 38', pour celles des noix 32 qui sont intermédiaires entre les extrémités des profilés d'ossature 10.

## Revendications

1. Profilé d'ossature, notamment pour armoire pour appareillages électriques, du genre comportant une paroi (11), dite ci-après par simple commodité paroi de fermeture, sur laquelle est rapporté au moins un quelconque accessoire d'équipement (12) ; caractérisé en ce que sa paroi de fermeture (11) est équipée par avance, en atelier, d'au moins une noix (32), qui, distincte dudit quelconque accessoire d'équipement (12), est en saillie sur la paroi de fermeture (11) et reçoit cet accessoire d'équipement (12), chaque dit quelconque accessoire d'équipement étant pris parmi divers accessoires d'équipement (12A, 12B, 12C, 12D, 12E) présentant tous des moyens d'assujettissement (60) à ladite noix (32), de sorte que ladite noix est apte à le recevoir de manière indifférenciée.

2. Profilé d'ossature suivant la revendication 1, caractérisé en ce que, pour le passage d'un organe de fixation (38, 38') propre à sa fixation, la noix (32) comporte, sur toute son épaisseur, perpendiculairement à la face d'appui (34) par laquelle elle est apte à être adossée à la paroi de fermeture (11), au moins un perçage (39), dit ci-après, par simple commodité, perçage transversal, et, en correspondance, la paroi de fermeture (11) présente elle-même un perçage (26).

3. Profilé d'ossature suivant la revendication 2, caractérisé en ce que la noix (32) ne comporte qu'un perçage transversal (39), et il lui est associé des moyens de blocage en rotation propres à en assurer le maintien autour de l'axe de ce perçage transversal (39).

4. Profilé d'ossature suivant la revendication 3, caractérisé en ce que, la paroi de fermeture (11) présentant latéralement des parties de raccordement (22), qui, encadrant sa partie médiane (23), sont obliques par rapport à celle-ci, la noix (32) s'étend latéralement jusqu'aux dites parties de raccordement (22) de la paroi de fermeture (11), et les moyens de blocage en rotation qui lui sont associés résultent notamment de ce que, pour contact avec celles-ci, elle présente latéralement, de manière complémentaire, sur la face d'appui (34) par laquelle elle est apte à être adossée à la paroi de fermeture (11), des facettes obliques (42).

5. Profilé d'ossature suivant l'une quelconque des revendications 1 à 4, caractérisé en ce que la noix (32) présente, en saillie sur la face d'appui (34) par laquelle elle est apte à être adossée à la paroi de fermeture (11), au moins un ergot (44, 44'), et, en correspondance, la paroi de fermeture (11) présente elle-même, pour engagement dudit ergot, un évidement (25).

6. Profilé d'ossature suivant la revendication 5, caractérisé en ce que la noix (32) présente, en saillie sur sa face d'appui (34), en étant chacun respectivement disposés aux sommets d'un quadrilatère rectangle dont deux des côtés sont parallèles à la direction d'allongement (D) de l'ensemble, quatre ergots (44), et, en correspondance, la paroi de fermeture (11) présente latéralement deux évidements (25) de contour quadrangulaire allongés en boutonnière parallèlement à ladite direction d'allongement (D).

7. Profilé d'ossature suivant la revendication 6, caractérisé en ce que celles (45) des faces latérales desdits ergots (44) qui s'étendent globalement transversalement par rapport à la direction d'allongement (D) de l'ensemble sont en biais, en convergeant l'une vers l'autre, pour un même ergot (44), de la racine de cet ergot à son extrémité.

8. Profilé d'ossature suivant l'une quelconque des revendications 6, 7, caractérisé en ce que, pour un même ergot (44), l'une au moins des faces latérales (46) qui s'étendent globalement parallèlement à la direction d'allongement (D) de l'ensemble est en biais, en convergeant vers l'autre de la racine de cet ergot (44) à son extrémité.

9. Profilé d'ossature suivant la revendication 5, caractérisé en ce que la noix (32) présente, en saillie sur sa face d'appui (34), en étant parallèles l'un à l'autre et parallèles à la direction d'allongement (D), deux ergots (44') allongés suivant cette direction d'allongement (D), et, en correspondance, la paroi de fermeture (11) présente latéralement deux évidements (25) de contour quadrangulaire allongés en boutonnière parallèlement à ladite direction d'allongement (D).

10. Profilé d'ossature suivant l'une quelconque des revendications 6, 9 prise conjointement avec la revendication 4, caractérisé en ce que lesdits évidements (25) de la paroi de fermeture (11) affectent ses parties de raccordement (22), en mordant légèrement sur sa partie médiane (23).

11. Profilé d'ossature suivant l'une quelconque des revendications 1 à 10, caractérisé en ce que la face d'appui (34) que présente la noix (32) pour être apte à être adossée à la paroi de fermeture (11) est affectée transversalement, sur toute sa largeur, d'un lamage (48).

12. Profilé d'ossature suivant l'une quelconque des revendications 1 à 11, caractérisé en ce que pour assujettissement à elle d'un accessoire d'équipement (12), la noix (32) comporte, sur toute sa hauteur, parallèlement à la face d'appui (34) par laquelle elle est apte à être adossée à la paroi de fermeture (11) et parallèlement à la direction d'allongement (D) de l'ensemble, au moins un perçage (50), dit ci-après par simple commodité perçage longitudinal, apte à la mise en place d'un organe de retenue (62).

13. Profilé d'ossature suivant la revendication 12, caractérisé en ce que la noix (32) comporte parallèlement l'un à l'autre deux perçages longitudinaux (50).

14. Profilé d'ossature suivant l'une quelconque des revendications 1 à 13, caractérisé en ce que la noix (32) se présente sous la forme d'une plaquette massive dont les faces principales (33, 34) sont parallèles à la paroi de fermeture (11), et dont les tranches supérieure et inférieure (36) s'étendent parallèlement l'une à l'autre, perpendiculairement à la direction d'allongement (D) de l'ensemble.

15. Profilé d'ossature suivant la revendication 14, caractérisé en ce que les tranches latérales de la noix (32) sont chacune biseautées en coin par deux facettes obliques (42) qui s'étendent globalement parallèlement à la direction d'allongement (D) de l'ensemble.

16. Profilé d'ossature suivant l'une quelconque des revendications 1 à 15, caractérisé en ce que, la paroi de fermeture (11) reliant l'une à l'autre deux ailes (13) qui s'étendent globalement à l'équerre l'une par rapport à l'autre, et qui forment conjointement une arête (14) en avant de la paroi de fermeture (11), l'une au moins des ailes (13) présente un évidement (28) propre au passage d'un écrou (53).

17. Profilé d'ossature suivant les revendications 6 et 16, prises conjointement, caractérisé en ce que l'évidement (28) d'une aile (13) s'étend au droit d'un évidement (25) de la paroi de fermeture (11).

18. Profilé d'ossature suivant l'une quelconque des revendications 1 à 17, caractérisé en ce que sa paroi de fermeture (11) porte par avance, à distance les unes des autres, plusieurs noix (32).

19. Profilé d'ossature suivant la revendication 18, caractérisé en ce que les noix (32) les plus proches de ses extrémités participent à la fixation de jambages (55) à celles-ci.

20. Profilé d'ossature suivant la revendication 18, caractérisé en ce que les noix (32) intermédiaires entre ses extrémités sont chacune individuellement rapportées sur sa paroi de fermeture (11).

21. Profilé d'ossature suivant l'une quelconque des revendications 18 à 20, caractérisé en ce que les noix (32) que porte sa paroi de fermeture (11) sont toutes identiques entre elles.

22. Profilé d'ossature suivant l'une quelconque des revendications 1 à 21, caractérisé en ce que tout accessoire d'équipement (12) qui lui est associé présente deux bras (60) par lesquels il est apte à être engagé à la manière d'une chape sur une noix (32) portée par sa paroi de fermeture (11).

23. Profilé d'ossature suivant les revendications 12 et 22, prises conjointement, caractérisé en ce que les bras (60) dudit accessoire d'équipement (12) présentent chacun un perçage (61) pour le passage d'un organe de retenue (62).

24. Profilé d'ossature suivant la revendication 23, caractérisé en ce que ledit organe de retenue (62) est un simple axe à tête épaulée (64).

25. Profilé d'ossature suivant l'une quelconque des revendications 23, 24, caractérisé en ce que le perçage (61) que présente le bras (60) supérieur de l'accessoire d'équipement (12) forme à son débouché supérieur un dégagement (65) dans lequel peut s'encastrer la tête épaulée (64) de l'axe formant l'organe de retenue (62) et qui débouche latéralement par une encoche (66).

26. Profilé d'ossature suivant l'une quelconque des revendications 1 à 25, caractérisé en ce qu'il lui est associé, en tant qu'accessoire d'équipement (12) à rapporter sur sa paroi de fermeture (11), au moins un embout (12A) qui, doté d'un crochet (71), est apte à l'encliquetage d'une paroi latérale (70) de l'armoire concernée.

27. Profilé d'ossature suivant la revendication 26, caractérisé en ce que, pour appui sur le profilé d'ossature, ledit embout (12A) présente une languette élastiquement déformable (73).

28. Profilé d'ossature suivant l'une quelconque des revendications 1 à 27, caractérisé en ce qu'il lui est associé, en tant qu'accessoire d'équipement (12) à rapporter sur sa paroi de fermeture (11), au moins un charnon (12B) apte à l'articulation d'une porte (80) ou d'une quelconque autre paroi.

29. Profilé d'ossature suivant l'une quelconque des revendications 1 à 28, caractérisé en ce qu'il lui est associé, en tant qu'accessoire d'équipement (12) à rapporter sur sa paroi de fermeture (11), au moins une gâche (12C).

30. Profilé d'ossature suivant l'une quelconque des revendications 1 à 29, caractérisé en ce qu'il lui est associé, en tant qu'accessoire d'équipement (12) à rapporter sur sa paroi de fermeture (11), au moins un verrou (12D).

31. Profilé d'ossature suivant l'une quelconque des revendications 1 à 30, caractérisé en ce qu'il lui est associé, en tant qu'accessoire d'équipement (12) à rapporter sur sa paroi de fermeture (11), au moins un étrier d'assemblage (12E), qui, avec un étrier d'assemblage (12E') de même type, est propre à participer à l'assujettissement l'un à l'autre de deux profilés d'ossature adjacents.

32. Profilé d'ossature suivant la revendication 31, caractérisé en ce que la partie médiane (92) d'un étrier d'assemblage (12E, 12E') présente, d'une part, en saillie à son dos, un tenon (95), qui, dans l'alignement d'un perçage (93), forme un berceau (96) pour le passage d'une vis (94), et, d'autre part, en creux, un évidement (97) qui est complémentaire du tenon (95).

33. Profilé d'ossature suivant l'une quelconque des revendications 28 à 32, caractérisé en ce que, sa paroi de fermeture (11) reliant l'une à l'autre deux ailes (13) qui, le long de leur bord, présentent chacune un retour (15) faisant avec leur partie immédiatement adjacente un dièdre (82) d'angle aigu (A), l'accessoire d'équipement (12B, 12C) qui lui est associé présente un bossage (83) en forme de coin, qui, de section transversale au moins en partie complémentaire de celle d'un tel dièdre (82), est apte à s'encastrer dans celui-ci.

## Patentansprüche

1. Skelettprofil, insbesondere für einen Schrank für elektrische Geräte mit einer Wand (11), im nachstehenden der Einfachheit halber Verschlußwand genannt, auf der wenigstens ein beliebiges Ausrüstungszubehörteil (12) angebracht ist, dadurch gekennzeichnet, daß seine Verschlußwand (11) im Werk im voraus mit wenigstens einer Nuß (32) ausgerüstet ist, die von dem Ausrüstungszubehörteil (12) getrennt ist, an der Verschlußwand (11) hervorsteht und dieses Ausrüstungszubehörteil (12) aufnimmt, wobei jedes solche Ausrüstungszubehörteil unter verschiedenen Ausrüstungszubehörteilen (12A, 12B, 12C, 12D, 12E) ausgewählt ist, die alle Mittel (60) zur Befestigung an der Nuß (32) aufweisen, so daß die Nuß dieses unterschiedslos aufnehmen kann.

2. Skelettprofil nach Anspruch 1, dadurch gekennzeichnet, daß die Nuß (32) für den Durchgang eines zu ihrer Befestigung dienenden Befestigungsorgans (38, 38') auf ihrer ganzen Dicke senkrecht zu der Auflagefläche (34), mit der sie an der Verschlußwand (11) anliegen kann, wenigstens eine Bohrung (39), im nachstehenden der Einfachheit halber Querbohrung genannt, aufweist und die Verschlußwand (11) ihrerseits in Übereinstimmung eine Bohrung (26) aufweist.

3. Skelettprofil nach Anspruch 2, dadurch gekennzeichnet, daß die Nuß (32) nur eine Querbohrung (39) aufweist und daß ihr Mittel zur Blockierung bezüglich Drehung zugeordnet sind, die ihren Halt um die Achse dieser Querbohrung (39) gewährleisten können.

4. Skelettprofil nach Anspruch 3, dadurch gekennzeichnet, daß, indem die Verschlußwand (11) seitlich Verbindungsteile (22) besitzt, die ihren mittleren Teil (23) säumen und zu diesem schräg sind, die Nuß (32) sich seitlich bis zu diesen Verbindungsteilen (22) der Verschlußwand (11) erstreckt und die ihr zugeordneten Mittel zur Blockierung bezüglich Drehung sich insbesondere daraus ergeben, daß sie für den Kontakt mit diesen seitlich ergänzend auf der Auflagefläche (34), mit der sie an der Verschlußwand (11) anliegen kann, schräge Facetten (42) aufweist.

5. Skelettprofil nach einem der Ansprüche 1 bis 4, dadurch gekennzeichnet, daß die Nuß (32) wenigstens eine Nase (44, 44') besitzt, die auf der Auflagefläche (34), mit der sie an der Verschlußwand (11) anliegen kann, hervorsteht, und die Verschlußwand (11) ihrerseits in Entsprechung zur Einführung dieser Nase eine Aussparung (25) besitzt.

6. Skelettprofil nach Anspruch 5, dadurch gekennzeichnet, daß die Nuß (32) vier auf der Auflagefläche (34) hervorstehende Nasen (44) besitzt, deren jede jeweilig an den Ecken eines rechtwinkeligen Vierecks angeordnet ist, von dem zwei Seiten zur Längserstreckungsrichtung (D) der Einheit parallel sind, und daß die Verschlußwand (11) in Entsprechung seitlich zwei Aussparungen (25) mit rechtwinkeligem Umriß besitzt, die in Form eines Langlochs parallel zur Längserstreckungsrichtung (D) langgestreckt sind.

7. Skelettprofil nach Anspruch 6, dadurch gekennzeichnet, daß diejenigen (45) der Seitenflächen der Nasen (44), die sich insbesondere quer zur Längserstreckungsrichtung (D) der Einheit erstrecken, abgeschrägt sind, indem sie bei ein und derselben Nase von der Wurzel dieser Nase zu ihrem Ende aufeinander zu konvergieren.

8. Skelettprofil nach einem der Ansprüche 6, 7, dadurch gekennzeichnet, daß bei ein und derselben Nase (44) wenigstens eine der Seitenflächen (46), die sich insbesondere parallel zur Längserstreckungsrichtung (D) der Einheit erstrecken, abgeschrägt ist, indem sie von der Wurzel dieser Nase (44) zu ihrem Ende auf die andere zu konvergiert.

9. Skelettprofil nach Anspruch 5, dadurch gekennzeichnet, daß die Nuß (32) auf ihrer Auflagefläche (34) vorspringend zwei zueinander und zur Längserstrekkungsrichtung (D) parallele Nasen (44') besitzt, die in dieser Längserstreckungsrichtung (D) langgestreckt sind, und die Verschlußwand (11) in Entsprechung seitlich zwei Aussparungen (25) mit rechtwinkeligem Umriß besitzt, die in Form eines Langlochs parallel zu dieser Längserstreckungsrichtung (D) langgestreckt sind.

10. Skelettprofil nach einem der Ansprüche 6, 9 zusammen mit Anspruch 4, dadurch gekennzeichnet, daß die Aussparungen (25) der Verschlußwand (11) sich auf ihren Verbindungsteilen (22) erstrecken, indem sie leicht auf ihren Mittelteil (23) übergreifen.

11. Skelettprofil nach einem der Ansprüche 1 bis 10, dadurch gekennzeichnet, daß die Auflagefläche (34), die die Nuß (32) besitzt, um an die Verschlußwand (11) angelegt zu werden, in Querrichtung auf ihrer ganzen Breite mit einer Einsenkung (48) versehen ist.

12. Skelettprofil nach einem der Ansprüche 1 bis 11, dadurch gekennzeichnet, daß die Nuß (32) zur Anbringung eines Ausrüstungszubehörteils (12) an ihr auf ihrer ganzen Höhe parallel zur Auflagefläche (34), mit der sie an die Verschlußwand angelegt werden kann, und parallel zur Längserstreckungsrichtung (D) der Einheit wenigstens eine Bohrung (50) umfaßt, der Einfachheit halber Längsbohrung genannt, die für die Anbringung eines Halteorgans (62) geeignet ist.

13. Skelettprofil nach Anspruch 12, dadurch gekennzeichnet, daß die Nuß (32) parallel zueinander zwei Längsbohrungen (50) aufweist.

14. Skelettprofil nach einem der Ansprüche 1 bis 13, dadurch gekennzeichnet, daß die Nuß (32) die Form einer massiven Plakette hat, deren Hauptseiten (33, 34) zur Verschlußwand (11) parallel sind und deren obere und untere Schmalseiten (36) sich parallel zueinander und senkrecht zur Längserstreckungsrichtung (D) der Einheit erstrecken.

15. Skelettprofil nach Anspruch 14, dadurch gekennzeichnet, daß die seitlichen Schmalseiten der Nuß (32) jeweils keilförmig durch zwei schräge Facetten (42) abgeschrägt sind, die sich global parallel zur Längserstreckungsrichtung (D) der Einheit erstrecken.

16. Skelettprofil nach einem der Ansprüche 1 bis 15, dadurch gekennzeichnet, daß, indem die Verschlußwand (11) zwei Schenkel (13) miteinander verbindet, die sich global rechtwinkelig zueinander erstrecken und zusammen bezüglich der Verschlußwand (11) nach vorne eine Kante (14) bilden, wenigstens einer der Schenkel (13) eine Aussparung (28) für den Durchgang einer Mutter (53) besitzt.

17. Skelettprofil nach den Ansprüchen 6 und 16 zusammen, dadurch gekennzeichnet, daß die Aussparung (28) eines Schenkels (13) sich in der Höhe einer Aussparung (25) der Verschlußwand (11) erstreckt.

18. Skelettprofil nach einem der Ansprüche 1 bis 17, dadurch gekennzeichnet, daß seine Verschlußwand von vornherein in einem Abstand voneinander mehrere Nüsse (32) trägt.

19. Skelettprofil nach Anspruch 18, dadurch gekennzeichnet, daß die Nüsse (32), die seinen Enden am nächsten gelegen sind, an der Befestigung von Füßen (55) an diesen teilnehmen.

20. Skelettprofil nach Anspruch 18, dadurch gekennzeichnet, daß die zwischen seinen Enden gelegenen Nüsse (32) jeweils einzeln an seiner Verschlußwand (11) angebracht sind.

21. Skelettprofil nach einem der Ansprüche 18 bis 20, dadurch gekennzeichnet, daß die Nüsse (32), die seine Verschlußwand (11) trägt, alle untereinander identisch sind.

22. Skelettprofil nach einem der Ansprüche 1 bis 21, dadurch gekennzeichnet, daß jedes Ausrüstungszubehörteil (12), das ihm zugeordnet ist, zwei Arme (60) besitzt, mit denen es nach der Art einer Gabel auf eine von seiner Verschlußwand (11) getragene Nuß (32) aufgesteckt werden kann.

23. Skelettprofil nach den Ansprüchen 12 und 22 zusammen, dadurch gekennzeichnet, daß die Arme (60) des Ausrüstungszubehörteils (12) jeweils eine Bohrung für den Durchgang eines Halteorgans (62) besitzen.

24. Skelettprofil nach Anspruch 23, dadurch gekennzeichnet, daß das Halteorgan (62) eine einfache Achse mit abgesetztem Kopf (64) ist.

25. Skelettprofil nach einem der Ansprüche 23, 24, dadurch gekennzeichnet, daß die Bohrung (61), die der obere Arm (60) des Ausrüstungszubehörteils (12) besitzt, an seiner oberen Mündung eine Ausnehmung (65) bildet, in die der abgesetzte Kopf (64) der das Halteorgan (62) bildenden Achse eingelassen werden kann und die seitlich über eine Aussparung (66) ausmündet.

26. Skelettprofil nach einem der Ansprüche 1 bis 25, dadurch gekennzeichnet, daß ihn als an seiner Verschlußwand (11) anzubringendes Ausrüstungszubehörteil (12) wenigstens ein Aufsatz (12A) zugeordnet ist, der mit einem Haken (71) versehen ist und die Einklinkung einer seitlichen Wand (70) des betreffenden Schranks gestattet.

27. Skelettprofil nach Anspruch 26, dadurch gekennzeichnet, daß dieser Aufsatz (12A) für die Auflage auf dem Skelettprofilteil eine elastisch verformbare Zunge (73) besitzt.

28. Skelettprofil nach einem der Ansprüche 1 bis 27, dadurch gekennzeichnet, daß ihm als an seiner Verschlußwand (11) anzubringendes Ausrüstungszubehörteil (12) wenigstens ein Scharnier (12B) zugeordnet ist, das die Anlenkung einer Tür (80) oder einer beliebigen anderen Wand gestattet.

29. Skelettprofil nach einem der Ansprüche 1 bis 28, dadurch gekennzeichnet, daß ihm als an seiner Verschlußwand (11) anzubringendes Ausrüstungszubehörteil (12) wenigstens ein Schließorgan (12C) zugeordnet ist.

30. Skelettprofil nach einem der Ansprüche 1 bis 29, dadurch gekennzeichnet, daß ihm als an seiner Verschlußwand (11) anzubringendes Ausrüstungszubehörteil (12) wenigstens ein Riegel (12D) zugeordnet ist.

31. Skelettprofil nach einem der Ansprüche 1 bis 30, dadurch gekennzeichnet, daß ihm als an seiner Verschlußwand (11) anzubringendes Ausrüstungszubehörteil (12) wenigstens ein Montagebügel (12E) zugeordnet ist, der zusammen mit einem Montagebügel (12E') vom selben Typ geeignet ist, an der gegenseitigen Befestigung von zwei benachbarten Skelettprofilen teilzunehmen.

32. Skelettprofil nach Anspruch 31, dadurch gekennzeichnet, daß der mittlere Teil (92) eines Montagebügels (12E, 12E') einerseits eine an seinem Rücken hervorstehende Nase (95), die mit einer Bohrung (93) in einer Linie liegt und ein Lager (96) für den Durchgang einer Schraube (94) bildet, und andererseits eine Aussparung (97) besitzt, die zur Nase (95) komplementär ist.

33. Skelettprofil nach einem der Ansprüche 28 bis 32, dadurch gekennzeichnet, daß, wenn seine Verschlußwand (11) zwei Schenkel (13) miteinander verbindet, die längs ihres Randes jeweils eine Abwinklung (15) aufweisen, die mit ihrem unmittelbar benachbarten Teil einen die Dieder (82) mit spitzem Winkel (A) bildet, das ihm zugeordnete Ausrüstungszubehörteil (12B, 12C) eine keilförmige Erhebung (63) besitzt, deren Querschnitt wenigstens teilweise zu dem eines solchen Dieders (82) komplementär ist und die in diesen eingelassen werden kann.

## Claims

1. A shaped framework member, in particular for a cabinet for electrical apparatuses, of the kind comprising a wall (11), referred to hereinafter for convenience as the closure wall, to which at least one equipment accessory (12) of any kind is mounted, characterised in that its closure wall (11) is fitted in advance in a workshop with at least one core member (32) separate from said equipment accessory (12), which projects from said closure wall (11) and receives the said equipment accessory (12), each of said equipment accessories being taken by various equipment accessories (12A, 12B, 12C, 12D, 12E), all having means (60) for fixture to said support core member (32), in such a way that said support core member is capable of receiving it in any which way.

2. A shaped framework member according to claim 1, characterised in that, for passing a fixing member (38, 38') for fixing same, the support core member (32) is provided over its entire thickness and perpendicularly to the contact face (34) with which it is capable of being applied against the closure wall (11) with at least one opening (39), referred to hereinafter for convenience as the transverse opening, and at a corresponding position the closure wall (11) itself has an opening (26).

3. A shaped framework member according to claim 2, characterised in that the support core member (32) comprises only one transverse opening (39) and associated therewith are rotation-blocking means for ensuring it is held in position about the axis of said transverse opening (39).

4. A shaped framework member according to claim 3, characterised in that, the closure wall (11) laterally having connecting portions (22) which framing its central portion (23) are inclined with respect thereto, the support core member (32) extends laterally as far as said connecting portions (22) of the closure wall (11), and the rotation-blocking means which are associated therewith are provided in particular by the fact that, for contact with said connecting portions, the support core member is laterally provided in a complementary manner with inclined surface portions (42) on the contact face (34) by way of which it is capable of being applied against the closure wall (11).

5. A shaped framework member according to any one of claims 1 to 4, characterised in that in projecting relationship on the contact face (34) by way of which it is capable of being applied against the closure wall (11), the support core member (32) has at least one lug (44, 44') and at a corresponding position the closure wall (11) itself has an aperture (25) for engagement of said lug.

6. A shaped framework member according to claim 5, characterised in that, in projecting relationship on its contact face (34), the support core member (32) has four lugs (44), each being disposed at the respective corners of a rectangular quadrilateral of which two of the sides are parallel to the direction of elongation (D) of the assembly, and, at corresponding positions, the closure wall (11) laterally has two apertures (25) of quadrangular contour which are elongate in a slot-like configuration parallel to said direction of elongation (D).

7. A shaped framework member according to claim 6, characterised in that those ones (45) of the lateral faces of said lugs (44) which extend generally transversely with respect to the direction of elongation (D) of the assembly are slanting, converging towards each other, for the same lug (44), from the root of said lug to its end.

8. A shaped framework member according to either one of claims 6 and 7, characterised in that, for the same lug (44), one at least of the lateral faces (46) which extend generally parallel to the direction of elongation (D) of the assembly is slanting, converging towards the other from the root of said lug (44) to its end.

9. A shaped framework member according to claim 5, characterised in that, in projecting relationship on its contact face (34), the support core member (32) has two lugs (44') which are elongate in said direction of elongation (D), being parallel to each other and parallel to the direction of elongation (D), and at corresponding positions the closure wall (11) laterally has two apertures (25) of quadrangular contour which are elongate in a slot-like shape parallel to said direction of elongation (D).

10. A shaped framework member according to either one of Maims 6 and 9 in combination with claim 4, characterised in that said apertures (25) in the closure wall (11) involve its connecting portions (22) while slightly encroaching on to its central portion (23).

11. A shaped framework member according to any one of claims 1 to 10, characterised in that the contact face (34) that the support core member (32) has for it to be capable of being applied to the closure wall (11) is transversely affected over its entire width by a facing (48).

12. A shaped framework member according to any one of claims 1 to 11, characterised in that, for fixing an equipment accessory (12) thereto, the support core member (32) comprises, over its entire height and parallel to the contact face (34) by way of which it is capable of being applied to the closure wall (11) and parallel to the direction of elongation (D) of the assembly, at least one opening (50), referred to hereinafter for convenience as the longitudinal opening, which is suitable for fitting a retaining member (62) in position.

13. A shaped framework member according to claim 12, characterised in that the support core member (32) comprises two longitudinal openings (50) in mutually parallel relationship.

14. A shaped framework member according to any one of claims 1 to 13, characterised in that the support core member (32) is in the form of a solid plate portion whose main faces (33, 34) are parallel to the closure wall (11) and whose upper and lower edge faces (36) extend parallel to each other perpendicularly to the direction of elongation (D) of the assembly.

15. A shaped framework member according to claim 14, characterised in that the lateral edge faces of the support core member (32) are each bevelled in a wedge-like configuration by two inclined surface portions (42) which extend generally parallel to the direction of elongation (D) of the assembly.

16. A shaped framework member according to any one of claims 1 to 15, characterised in that, the closure wall (11) connecting together two limbs (13) which extend generally at a right angle relative to each other and which jointly form a ridge (14) in front of the closure wall (11), one at least of the limbs (13) has an aperture (28) for a nut (53) to pass therethrough.

17. A shaped framework member according to claims 6 and 16 in combination, characterised in that the aperture (28) in a limb (13) extends in line with an aperture (25) in the closure wall (11).

18. A shaped framework member according to any one of claims 1 to 17, characterised in that its closure wall (11) carries a plurality of support core members (32) in advance, at spacings from each other.

19. A shaped framework member according to claim 18, characterised in that the support core members (32) which are closest to its ends are involved in fixing leg means (55) to same.

20. A shaped framework member according to claim 18, characterised in that the support core members (32) which are intermediate between its ends are each individually fitted to its closure wall (11).

21. A shaped framework member according to any one of claims 18 to 20, characterised in that the support core members (32) carried by its closure wall (11) are all identical to each other.

22. A shaped framework member according to any one of claims 1 to 21, characterised in that any equipment accessory (12) which is associated therewith has two arms (60) by way of which it is capable of being engaged in a fork-like configuration on to a support core member (32) carried by its closure wall (11).

23. A shaped framework member according to claims 12 and 22 in combination, characterised in that the arms (60) of said equipment accessory (12) each have an opening (61) for a retaining member (62) to pass therethrough.

24. A shaped framework member according to claim 23, characterised in that said retaining member (62) is a simple axis member with shouldered head (64).

25. A shaped framework member according to either one of claims 23 and 24, characterised in that the opening (61) in the upper arm (60) of the equipment accessory (12) forms at its upper mouth end a relief portion (65) into which can fit the shouldered head (64) of the axis member forming the retaining member (62) and which opens laterally by way of a notch (66).

26. A shaped framework member according to any one of claims 1 to 25, characterised in that associated therewith as the equipment accessory (12) to be mounted in its closure wall (11) is at least one end connector (12A) which, provided with a hook (71), is suitable for latching engagement of a side wall (70) of the cabinet in question.

27. A shaped framework member according to claim 26, characterised in that, for bearing against the shaped framework member, said end connector (12A) has an elastically deformable tongue portion (73).

28. A shaped framework member according to any one of claims 1 to 27, characterised in that associated therewith as the equipment accessory (12) to be mounted to its closure wall (11), is at least one hinge knuckle (12B) for suitable pivotal mounting of a door (80) or any other wall.

29. A shaped framework member according to any one of claims 1 to 28, characterised in that associated therewith as the equipment accessory (12) to be mounted to its closure wall (11) is at least one lock keeper (12C).

30. A shaped framework member according to any one of claims 1 to 29, characterised in that associated therewith as the equipment accessory (12) to be mounted to its closure wall (11) is at least one lock (12D).

31. A shaped framework member according to any one of claims 1 to 30, characterised in that associated therewith as the equipment accessory (12) to be mounted to its closure wall (11) is at least one assembly stirrup (12E) which, with an assembly stirrup (12E') of the same type, is suitable for participating in fastening two adjacent shaped framework members to each other.

32. A shaped framework member according to claim 31, characterised in that the central portion (92) of an assembly stirrup (12E, 12E') has on the one hand in projecting relationship at its back a lug (95) which, in alignment with an aperture (93), forms a cradle (96) for passing a screw (94) and on the other hand, in recessed relationship, an opening (97) which is complementary to the lug (95).

33. A shaped framework member according to any one of claims 28 to 32, characterised in that, its closure wall (11) connecting together two limbs (13) which, along their edge, each have a return portion (15) which with their immediately adjacent part form a dihedron (82) with an acute angle (A), the equipment accessory (12B, 12C) which is associated therewith has a wedge-shaped boss (83) that, of cross-section which is at least in part complementary to that of such a dihedron (82), is capable of fitting into same.
